# EUROPÄISCHE PATENTSCHRIFT

(11) **EP 2 096 713 B1**
(45) Veröffentlichungstag und Bekanntmachung des Hinweises auf die Patenterteilung: **25.01.2012**
(21) Anmeldenummer: 09002724.4
(22) Anmeldetag: 26.02.2009
(51) Int. Cl.: H01R 4/30, H01R 13/641, G01R 27/20, G01R 31/04, H05K 7/14, H05K 1/02

(54) **Schaltungsanordnung zur Überprüfung einer korrekten Verbindung von Leiterplatten in Gehäusen**
Switching assembly for testing a correct connection of circuit boards in housings
Agencement de commutation destiné à la vérification d'une liaison correcte de plaquettes dans des boîtiers

(30) Priorität: 27.02.2008 DE 102008011289
(43) Veröffentlichungstag der Anmeldung: 02.09.2009
(73) Patentinhaber: KNORR-BREMSE Systeme für Nutzfahrzeuge GmbH, 80809 München (DE)
(72) Erfinder: Arlt, Andreas, 71672 Marbach am Neckar (DE); Feucht, Thomas, 71299 Wimsheim (DE)
(74) Vertreter: Mattusch, Gundula

(56) Entgegenhaltungen:
- DE-A1-102007 020 882
- DE-C1- 4 331 954
- JP-A- 9 159 558
- US-A- 6 160 402
- US-A1- 2004 150 523
- US-A1- 2007 207 636
- US-B1- 7 066 039

## Beschreibung

Die Erfindung bezieht sich auf eine Schaltungsanordnung zur Überprüfung einer korrekten Verbindung von Leiterplatten in Gehäusen gemäß dem Oberbegriff des Patentanspruches 1.

Eine solche Schaltungsanordnung ist aus der DE 43 31 954 C1 bekannt. Auf einer Leiterbahnplatte stellen metallische Befestigungselemente elektrische Verbindungen zwischen Leiterbahnabschnitten her. Als mechanische Befestigungselemente dienen Schrauben, deren Schraubenköpfe Leiterbahnabschnitte miteinander und mit einem Gerätegehäuse elektrisch verbinden. Die jeweils durch eine Schraube verbundenen Leiterbahnabschnitte sind in einer Reihenschaltung angeordnet. Eine Strommesseinrichtung mit einer Spannungsquelle und einem Widerstand sowie zwei Prüfelektroden ermöglicht eine Überprüfung, ob alle durch die Verbindungsstellen gebildeten Schalter geschlossen sind.

Die US 6,160,402 A beschreibt eine ähnliche Vorrichtung zur Überprüfung der korrekten Befestigung einer Leiterplatte mit einer Schraube, deren Kopf Leiterbahnabschnitte elektrisch miteinander verbindet und damit einen elektrischen Schalter bildet. Hier wird durch einen Messwiderstand in Verbindung mit einer Spannungsquelle und einem Voltmeter überprüft, ob der Schalter geschlossen ist.

Aus der US 7,066,039 B1 ist bekannt, zur Überprüfung der Befestigung einer Platine in einem Gehäuse einen Strompfad zwischen Gehäuse und Leiterplatte zu bilden und dessen Widerstand auszuwerten.

Die US 2007/0207636 A1 zeigt eine Leiterbahnplatte mit einem Befestigungsloch zur Befestigung der Leiterbahnplatte an einem Gehäuse. Ein spulenförmiges Leiterbahnmuster ist ringsum das Durchgangsloch angeordnet. Mit einer Messspule kann ein Magnetfeld der Spule gemessen werden.

Die US 2004/0150523 A1 zeigt Sensoren zur Messung der Befestigung einer Leiterbahnplatte an einem Gehäuse. Elektrische Kontakte werden geschlossen und bilden einen elektrischen Pfad, wenn der Sensor an einer entsprechenden Oberfläche befestigt ist.

Die JP 09159558 A beschreibt eine Vorrichtung zur Überprüfung der Befestigung einer Schraube an einem Gegenstand. Durch Messung des elektrischen Widerstandes zwischen der Schraube und dem Gegenstand kann überprüft werden, ob die Schraube fest sitzt, da der elektrische Widerstand vom Anpressdruck abhängt.

Mit den bekannten Schaltungsanordnungen, insbesondere der eine Reihenschaltung verwendenden DE 43 31 954 C1 ist es nur möglich, zu überprüfen, ob alle Verbindungsstellen korrekt verbunden sind. Es lässt sich aber nicht feststellen, ob nur eine oder mehrere Verbindungen nicht korrekt hergestellt wurden.

Aufgabe der Erfindung ist es, die Vorrichtung der eingangs genannten Art dahingehend zu verbessern, dass überprüft werden kann, ob eine oder mehrere Verbindungen fehlerhaft sind.

Diese Aufgabe wird durch die im Patentanspruch 1 angegebenen Merkmale gelöst. Vorteilhafte Ausgestaltungen und weiterbildungen der Erfindung sind den Unteransprüchen zu entnehmen.

Nach der Erfindung liegen die elektrischen Verbindungen in Parallelschaltung, wobei jeder Verbindung ein Messwiderstand zugeordnet ist. Durch Messen des Gesamtwiderstandes kann man feststellen, wie viele der elektrischen Verbindungen hergestellt sind.

Im folgenden wird die Erfindung anhand eines Ausführungsbeispleles im Zummenhang mit der Zeichnung ausführilcher erläutert. Es zeigt:
- Figur 1: einegesehnittene Seitenansicht einer mit einem Gehäuse verschraubten Leiter- platte,
- Figur 2: eine schematische Draufsicht der Leiter- platte der Figur 1;
- Figur 3: eine elektrisches Ersatzschaltbild der Schaltungsanordnung für das Ausfüh- rungsbelsplel der Figuren 1 und 2;

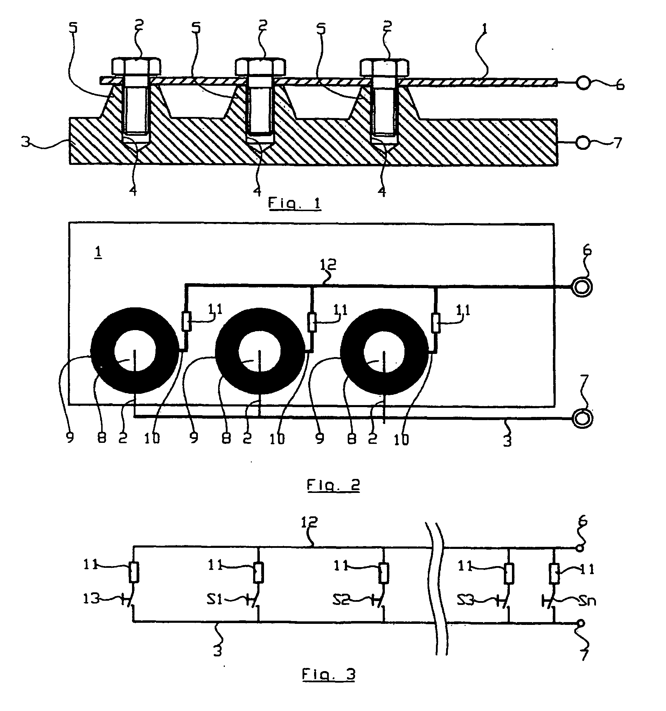

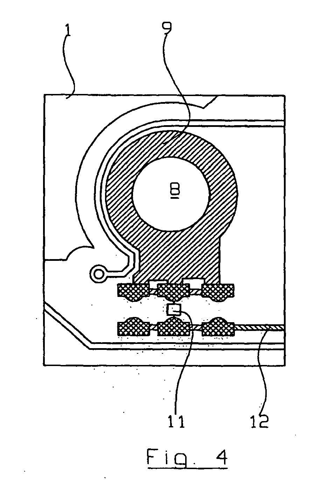

Figur 1 zeigt eine Leiterplatte 1, die mit einer oder mehreren Schrauben 2 an einem Gehäuse 3 befestigt ist. Das Gehäuse 3 hat für jede Schraube 2 eine Gewindebohrung 4 an Kontaktsockeln 5. Seibstverständlich können statt Gewindebohrungen auch einfache Durchgangsbohrungen vorgesehen sein und die Schraube mit einer Mutter befestigt werden.

Es sind auch andere Befestigungsarten zwischen der Leiterplatte und dem, Gehäuse 3 möglich, wie z.B. Nieten, Ankleben mit elektrisch leitfähigem Kontaktkleber oder sonstige bekannte Verbindungsarten.

Wichtig ist daβ zwischen dem Gehäuse 3 und vorbestimmten Bereichen der Leiterplatte 1 eine elektrische Verbindung hergestellt wird, was im dargestellten Ausführungsbeispiel durch die Schrauben 2 erfolgt.

An der Leiterbahnplatte 1 ist ein Prüfpin 6 vorhanden, der von außen zugänglich ist. In ähnilcher Weise ist am Gehäuse 3 ein elektrischer Anschluß 7 vorgesehen, so daß die nachfolgend noch zu beschreibende Zeichnung über den Prüfpin 6 und den Anschluß 7 zugänglich ist.

Figur 2 zeigt die Leiterbahnplatte 1 In schematischer Draufsicht. Die Leiterbahnplatte 1 hat für jede Schraube 2 eine Durchgangsbohrung 8, um die herum ein elektrisch leitfähiger Ring 9 aufgebracht ist. Beispielsweise kann dieser Ring als Kupfer- oder Silberielterbahn oder auch aus sonstigem leitfähigen Lack aufgedruckt sein. Jeder Ring 9 Ist Ober eine Leiterbahn 10 mit einem zugeordneten Meßwiderstand 11 verbunden, wobei alle Meßwiderstände 11 mit einer gemeinsamen Leiterbahn 12 verbunden sind, die mit dem Prüfpin 6 verbunden ist.

Werden die Schrauben 2 eingeschraubt, so wird bei richtiger Verschraubung ihr Kopf den jeweiligen Ring 9 kontaktieren. Die Schraube stellt damit eine elektrische Verbindung zwischen dem Ring 9 und dem Gehäuse 3 her. An dem Prüfpin 6 und dem Anschluß 7 läßt sich dann der elektrische Widerstand messen, der bei korrekter Verschraubung dem Gesamtwiderstand der Parallelschaltung aller Meßwiderstände 11 entspricht. Über den gemessenen Widerstandswert läßt sich auch feststellen, wie viele der elektrischen Verbindungen hergestellt wurden.

Im dargestellten Ausführungsbeispiel der Figuren 1 und 2 sind die elektrisch leitfähigen Ringe 9 an der dem Gehäuse 3 abgewandten Oberseite der Leiterplatte 1 angeordnet Sie werden von den Köpfen der Schrauben 2 kontaktiert. Eine solche Anordnung ist auch bei einer Nietverbindung geeignet.

Bei einer Kieb- oder sonstigen Kontaktverbindung können die Ringe 9 auch an der dem Gehäuse 3 zugewandten Unterseite der Leiterplatte 1 angeordnet sein, so daß sie unmittielbar die ihnen zugewandte Oberseite der Kontaktsockel 5 berühren, so daß die elektrische Verbindung nur durch die Berührung zwischen Ring 9 und Oberseite des Kontaktsockels 5 hergestellt wird und nicht Ober eine Schraube. Ansonsten ist die Wirkungsweise einer solchen Schaltung gleich der der Figuren 1 und 2.

Figur 3 zeigt das elektrische Ersatzschaltbild. Die Verbindung zwischen dem Ring 9, der Schraube 2 und dem Gehäuse 3 ist im Ersatzschaltbild ein elektrischer Schalter S1...Sn, der bei einwandfreiem Kontakt geschlossen ist. Im ausführungsbeispiel der Figur 3 liegt die Schaltung aus Schaltem S1 bis Sn, Meßwiderständen 11 in Parllelschaltung zwischen der Leiterbahn 12 und dem Gehäuse 3, welche wiederum mit dem Prüfpin 6 bzw. dem Anschluß 7 verbunden sind. Das Layout der Figur 6 zeigt einen Ausschnitt einer Leiterbahnplatte mit der Bohrung 8 und dem Ring 9, der vollflächig leitfähig ist, wobei der Widerstand 11 angelötet ist und den Ring 9 mit der Leiterbahn 12 verbindet. Weltere Leiterbahnen sind angedeutet, um zu zeigen, daß die Leiterplatte 1 beliebige sonstige Strukturen haben kann.

Dem Fachmann ist klar, daß je nach Anwendungszweck, wie z.B. Verschraubung, Verklebung etc. unterschiedliche Layouts gewählt werden können.

## Patentansprüche

1. Schaltungsanordnung zur Überprüfung einer korrekten Verbindung von Leiterplatten (1) in Gehäusen (3), die mehrere Verbindungsstellen zwischen der Leiterplatte (1) und dem Gehäuse (3) aufweist, die als elektrischer Schalter (S1...Sn) ausgebildet sind, die in einen Stromkreis geschaltet sind, der bei korrekter Verbindung geschlossen ist, wobei die Leiterplatte (1) an jeder Verbindungsstelle eine Kontaktfläche (9 ) hat, die jeweils durch ein elektrisch leitfähiges Verbindungsmittel (2) mit dem Gehäuse (3) elektrisch verbunden wird und einen elektrisch leitfähigen Kontakt bilden, wobei das Verbindungsmittel (2) gleichzeitig eine mechanische Verbindung zwischen der Leiterplatte (1) und dem Gehäuse (3) herstellt, **dadurch gekennzeichnet, dass** mehrere solcher elektrisch leitfähigen Kontakte in Parallelschaltung verschaltet sind, wobei in der ParallelShaltung jedem Kontakt jeweils ein Messwiderstand (11) zugeordnet ist.

2. Schaltungsanordnung nach Anspruch 1, **dadurch gekennzeichnet, dass** der Stromkreis durch das Verbindungsmittel (2) zwischen dem Gehäuse (3) und der Leiterplatte (1) geschlossen wird.

3. Schaltungsanordnung nach Anspruch 1 oder 2, **dadurch gekennzeichnet, dass** das Verbindungsmittel eine Schraube (2) oder ein Niet ist, die bzw. der den elektrischen Kontakt berührt und damit eine elektrische Verbindung zwischen dem Kontakt und dem Gehäuse (3) herstellt.

## Claims

1. Circuit arrangement for checking a correct connection of printed circuit boards (1) in housings (3), comprising several connecting sites between said printed circuit board (1) and said housing (3), which are designed as electrical switches (S1...Sn) which are connected in a circuit that is closed when the connection is correct, with said printed circuit board (1) having one contact area (9) at each connecting site, which is connected respectively to said housing (3) by means of an electrically conductive connecting means (2) and which forms an electrically conductive contact, wherein said connecting means (2) establishes, at the same time, a mechanical connection between said printed circuit board (1) and said housing (3), **characterized in that** a plurality of such electrically conductive contacts are connected in a parallel circuit, with a respective measuring resistor (11) being associated with each contact in said parallel circuit.

2. Circuit arrangement according to Claim 1, **characterized in that** said circuit is closed by said connecting means (2) between said housing (3) and said printed circuit board (1).

3. Circuit arrangement according to Claim 1 or 2, **characterized in that** said connecting means is a screw (2) or a rivet that contacts said electrical contact, thus establishing an electrical connection between said contact and said housing (3).

## Revendications

1. Structure de circuit à contrôler une connexion correcte des cartes des circuits imprimés (1) dans des carters (3), comprenant plusieurs sites de connexion entre ladite carte des circuits imprimés (1) et ledit carter (3), qui sont conçus sous forme des commutateurs électriques (S1...Sn) reliés dans un circuit qui est fermé quand la connexion est correcte, à ladite carte des circuits imprimés (1) ayant une aire de contact (9) à chaque site de connexion, qui est reliée respectivement audit carter (3) moyennant un moyen de raccordement électriquement conductible (2) et qui constitue un contact électriquement conductible, dans lequel ledit moyen de raccordement (2) établit, au même temps, une connexion mécanique entre ladite carte des circuits imprimés (1) et ledit carter (3), **caractérisé en ce qu'**une pluralité de tels contacts électriquement conductibles sont reliés dans un circuit parallèle, à une résistance de mesure respective (11) étant affectée à chaque contact dans ledit circuit parallèle.

2. Structure de circuit selon la revendication 1, **caractérisé en ce que** ledit circuit est fermé par ledit moyen de raccordement (2) entre ledit carter (3) et ladite carte des circuits imprimés (1).

3. Structure de circuit selon la revendication 1 ou 2, **caractérisé en ce que** ledit moyen de raccordement est une vis (2) ou un rivet qui touche ledit contact électrique, en établissant ainsi une connexion électrique entre ledit contact et ledit carter (3).
